# EUROPEAN PATENT APPLICATION

(11) **EP 1 302 877 A1**
(43) Date of publication of application: **16.04.2003**
(21) Application number: 01947993.0
(22) Date of filing: 12.07.2001
(51) Int. Cl.: G06F 17/50, G06F 17/60

(54) **CIRCUIT DESIGN SUPPORT METHOD AND CIRCUIT DESIGN SUPPORT SYSTEM AND PROGRAM RECORDING MEDIUM**

(30) Priority: 19.07.2000 JP 2000219250; 03.07.2001 JP 2001202453
(71) Applicant: Toshiba Tec Kabushiki Kaisha, Tokyo, 101-8442 (JP)
(72) Inventor: USAMI, Yutaka, Ohitocho, Tagata-gun, Shizuoka 410-2303 (JP)
(74) Representative: Fuchs Mehler Weiss & Fritzsche
(86) International application number: JP0106060
(87) International publication number: WO02007015

(57) **Abstract**

A server system (12) transmits display information that allows selecting a circuit module, display information that allows designating a parameter of the circuit module, and display information that allows inputting circuit specifications to a client terminal (13) through a network (11). The server system acquires circuit module selection information, designated parameter information, and circuit specification information from the client terminal (13), simulates the electrical characteristics of the circuit, and transmits the determination result to the client terminal (13). With this arrangement, a circuit that meets the client's specifications is designed.

## Description

### Technical Field

The present invention relates to a circuit design support method and circuit design support system in a server system using a network, and a program recording medium and, more particularly, to a circuit design support method and circuit design support system in a server system which receives, through a network, circuit simulation request information transmitted from a client terminal and executes a circuit simulation on the basis of the request information, and a program recording medium.

### Background Art

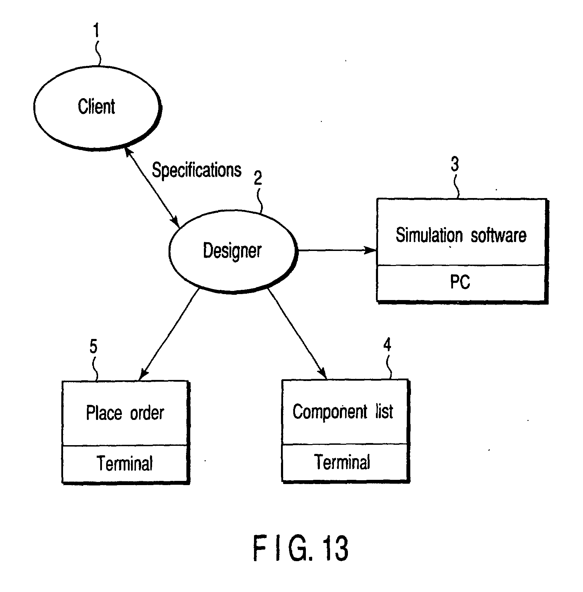

In receiving a circuit design order, a client 1 presents product specifications to a designer 2 for request, and the designer 2 designs a circuit that satisfies the requested product specifications, as shown in FIG. 13. At this time, the designer 2 designs by operating a personal computer 3 for executing circuit simulations or a terminal 4 on which a component list can be browsed to decide components. When circuit design is completed, the designer 2 places an order to a production department for that product by operating a terminal 5 for placing an order.

Various product specifications are received from clients: some have structures resembling standard articles, and some require completely new designs. For structures similar to standard articles, overall design is not always necessary, and therefore, relatively easy work often suffices. However, basically, a designer considers parts to be redesigned. The result sometimes changes depending on the designer's way of thinking.

Product specifications received from clients can be roughly classified into three types. A first type is compatible with a standard article. For a second type, standard articles are somewhat insufficient to satisfy the characteristics, though the specifications can be satisfied by changing component specifications without changing the circuit arrangement. For a third type, since the characteristics are not satisfied by standard articles, a new circuit must be constructed.

In these types, especially, the second type having specifications that can be satisfied by changing component specifications is easy to design as compared to the third type that requires new circuit construction. However, with the same design routine as for that for the third type, quick circuit design is impossible.

It is therefore an object of the present invention to provide a circuit design support method and circuit design support system which allow circuit design that meets specifications from a client and also allows quick circuit design for the client by causing a server system to acquire circuit module selection information and circuit specification information from a client terminal, execute circuit simulations, and notify the client terminal of the result of determination whether the result of executed simulations has satisfied the specifications, and a program recording medium.

### Disclosure of Invention

In a circuit design support method of the present invention, a server system receives, through a network, circuit simulation request information transmitted from a client terminal and executes a circuit simulation on the basis of the request information. In this case, a library in which a plurality of circuit modules that can perform circuit simulations are registered can be used on the network. Display information that allows selecting a circuit module from the library, display information that allows designating parameters of the circuit module, and display information that allows inputting circuit specification are transmitted to the client terminal. The server system receives the circuit modules selected in the client terminal, the parameters designated in the client terminal and the circuit specification input in the client terminal. The server system prepares for a circuit simulation by using the circuit modules. The server system then performs a simulation by applying the parameters. The server system determines whether the results of the simulation satisfy the circuit specification. The results of the determination are stored into a storage section. The results of the simulation are transmitted to the client terminal when the client terminal has access to the server system.

In a server system which receives, through a network, circuit simulation request information transmitted from a client terminal and executes a circuit simulation on the basis of the request information, a circuit design support system of the present invention comprises a library in which a plurality of circuit modules capable of circuit simulations are registered, means for transmitting to the client terminal display information that allows selecting a circuit module from the library, display information that allows designating a parameter of the circuit module, and display information that allows inputting circuit specifications, means for receiving the circuit module selected on the client terminal, the designated parameter, and the input circuit specifications, means for executing a circuit simulation using the selected circuit module in consideration of the designated parameter, means for determining whether a simulation result satisfies the circuit specifications, means for storing a determination result in a storage section, and means for transmitting the determination result in response to access from the client terminal.

A recording medium of the present invention records a program to cause a server system which receives, through a network, circuit simulation request information transmitted from a client terminal and executes a circuit simulation on the basis of the request information to implement a function of making a library in which a plurality of circuit modules capable of circuit simulations are registered usable on the network, a function of transmitting to the client terminal display information that allows selecting a circuit module from the library, display information that allows designating a parameter of the circuit module, and display information that allows inputting circuit specifications, a function of receiving the circuit module selected on the client terminal, the designated parameter, and the input circuit specifications, a function of executing a circuit simulation using the selected circuit module in consideration of the designated parameter, a function of determining whether a simulation result satisfies the circuit specifications and storing a determination result in a storage section, and a function of transmitting the determination result in response to access from the client terminal.

### Brief Description of Drawings

FIG. 1 is a block diagram showing the overall arrangement of a circuit design support system according to the present invention;
FIG. 2 is a flowchart showing processing of a management/determination server in the server system shown in FIG. 1;
FIG. 3 is a view showing a display window when display information for circuit unit selection is displayed on the client terminal shown in FIG. 1;
FIG. 4 is a view showing a display window when display information for circuit unit selection is displayed on the client terminal shown in FIG. 1;
FIG. 5 is a flowchart showing processing of a calculation server in the server system shown in FIG. 1;
FIG. 6 is a view showing a display window when similar recommended articles are displayed on the client terminal shown in FIG. 1;
FIG. 7 is a view showing a display window when a job list is displayed on the client terminal shown in FIG. 1;
FIG. 8 is a view showing a display window when "NG" is displayed on the client terminal shown in FIG. 1;
FIG. 9 is a view showing a display window when a dialog box that prompts placing of an order for a product is displayed on the client terminal shown in FIG. 1;
FIG. 10 is a flowchart showing processing of the management/determination server when a purchase button is clicked on the display window shown in FIG. 9;
FIG. 11 is a flowchart showing processing of the management/determination server in the server system when cancel reason information is acquired from the client terminal;
FIG. 12 is a view showing a display window switched when a cancel button is clicked on the display window shown in FIG. 9; and
FIG. 13 is a block diagram for explaining background art.

### Best Mode for Carrying Out of the Invention

The embodiment of the present invention will be described below with reference to the accompanying drawings.

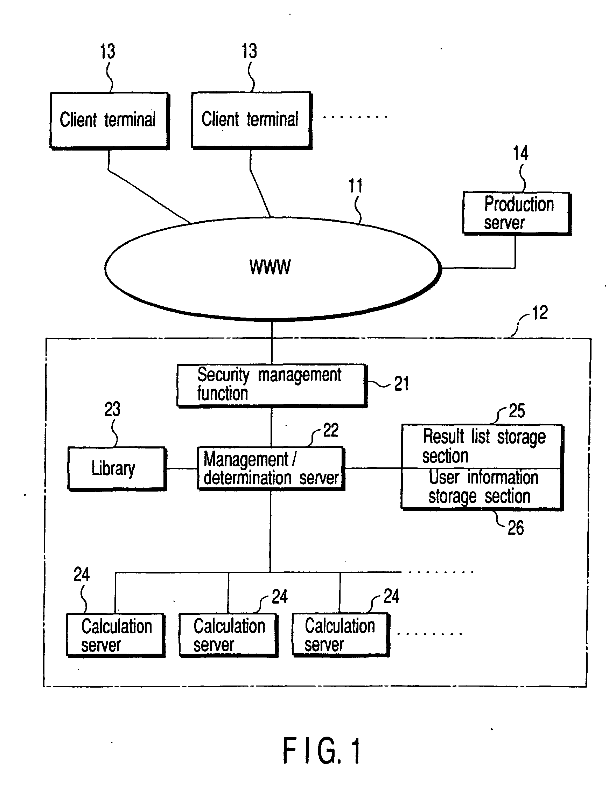

FIG. 1 is a block diagram showing the overall arrangement of a circuit design support system. A server system 12 for supporting circuit design, a plurality of client terminals 13 formed from personal computers, and a production server 14 installed in a production department that produces products on the basis of designed circuits are connected on a network 11 that provides a World Wide Web.

The server system 12 connects a management/determination server 22 to a line from the network 11 through a security management function section 21. A library 23 formed from a hard disk in which a plurality of circuit modules are registered, a plurality of calculation servers 24, and a result list storage section 25 and user information storage section 26 formed from hard disks are connected to the management/determination server 22.

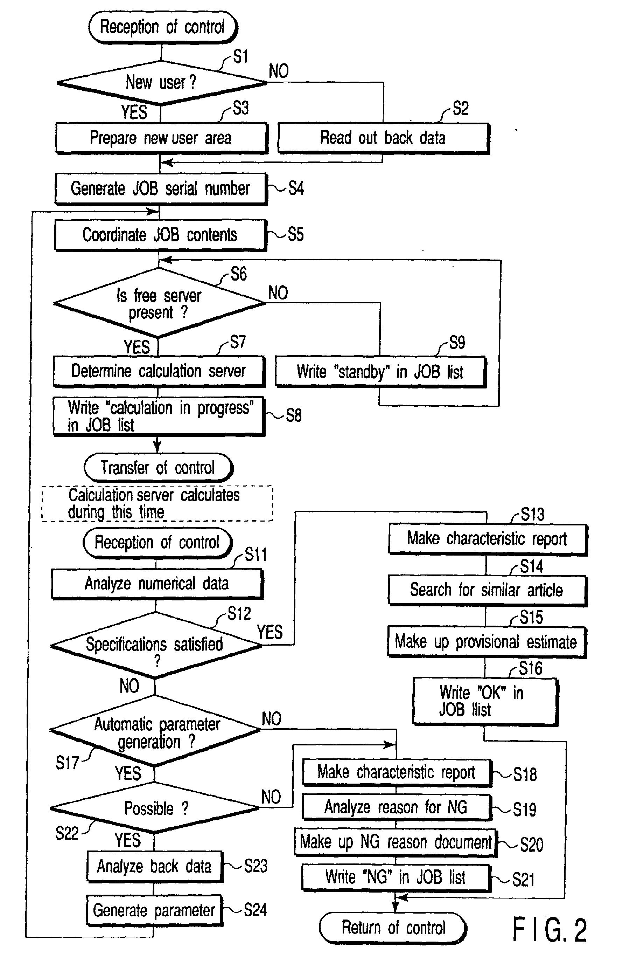

The management/determination server 22 in the server system 12 executes processing based on the flow chart shown in FIG. 2 in response to access from each client terminal 13. That is, when the client terminal 13 accesses the server system 12 through a World Wide Web browser, and a user as a client transmits an ID (identification number) and password, the management/determination server 22 in the server system 12 receives the control and, in S1, collates the ID and password with authentication data to determine whether the user is a new user.

If the user who is accessing the server system 12 has used the system in the past, the user's past data is read out from the user information storage section 26 as back data in S2. For a new user, a new user area is prepared in the user information storage section 26 in S3.

When user authentication is ended, the server system 12 outputs to the network 11 display information used to select a circuit module, change parameters of circuit modules, and input specifications of the circuit.

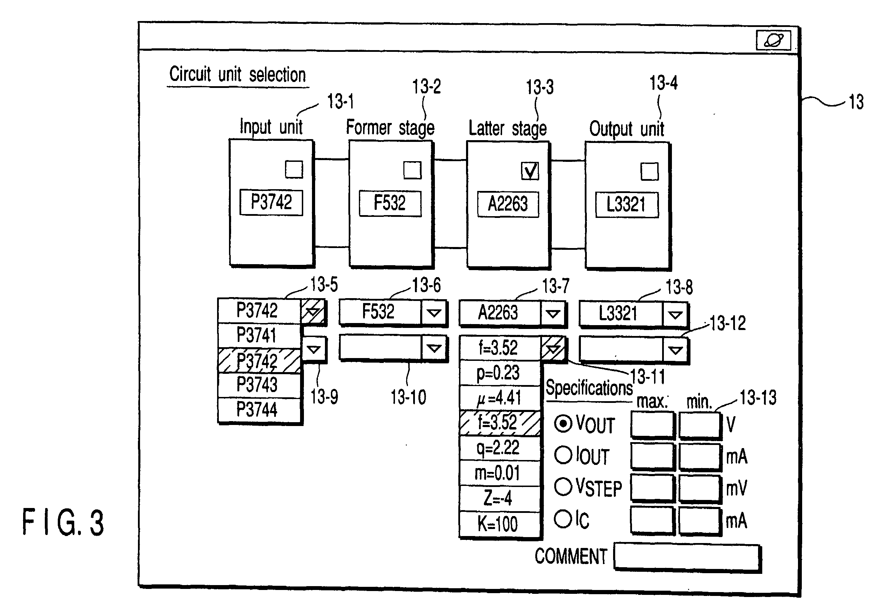

With this operation, display information for circuit module selection is displayed on the client terminal 13 that has accessed the server system, as shown in FIG. 3.

One complete circuit which can probably be expressed by combining a plurality of blocks is divisionally displayed as, e.g., an input unit 13-1, former stage 13-2, latter state 13-3, and output unit 13-4.

For the respective blocks, selection menus 13-5, 13-6, 13-7, and 13-8 for circuit module selection are displayed.

For example, when the pull-down menu bar of the selection menu 13-5 is clicked, a list of a plurality of circuit modules P3741, P3742, P3743, and P3744 is displayed for the input unit. These circuit modules are standard circuit modules and registered in the library 23.

The user can select, e.g., the circuit module P3742 as a desired circuit module. Similarly, a circuit module F532 is selected for the former stage 13-2. A circuit module A2263 is selected for the latter state 13-3. A circuit module L3321 is selected for the output unit 13-4.

Each circuit module has circuit information containing the names of circuit elements in the circuit module, the parameters of the circuit elements in the circuit module, and connection information between the circuit elements, and the characteristic parameters of the circuit module. As these parameters, standard parameters are set as initial values.

Some of the characteristic parameters of the circuit module can be changed by the user. Change menus 13-9, 13-10, 13-11, and 13-12 are displayed for this purpose.

For example, when the pull-down menu bar of the change menu 13-11 is clicked, changeable parameters in all the preset parameters of the circuit module A2263, i.e., p = 0.23, µ = 4.41, f = 3.52, q = 2.22, m = 0.01, z = -4, and k = 100 are displayed. These are preset standard parameters.

The user can select, e.g., the parameter f and change its value "3.52".

In addition, an input menu 13-13 used to input the specifications of the circuit is displayed. For example, MAX. and MIN. can be input for V_{OUT}, I_{OUT}, V_{STEP}, and I_{C}.

In this way, the user can designate circuit simulation request information on the display window of the client terminal 13. Although not illustrated, whether automatic parameter generation is to be validated or invalidated can be designated. Furthermore, conditions for an applied current or applied voltage, designation of an output observation place, and designation of a calculation result display style can be set.

When the user has completed circuit module selection, parameter change, and circuit specification input on the client terminal 13, he clicks the "OK" button. The selected circuit modules, changed parameters, and circuit specifications are transmitted from the client terminal 13 to the management/determination server 22 through the network 11 as request information.

The job sent by the user is present in the memory or on the hard disk in the management/determination server 22 during execution. After the user has logged out, the job is transferred to a storage device (not shown) and stored for a relatively long time.

In S4, the management/determination server 22 generates and assigns a unique job serial number to the request information sent from the user.

In S5, the management/determination server 22 coordinates works to be done by the calculation servers 24 in correspondence with the assigned job number. The contents of the works are described by specific command sequences arranged between the management/determination server 22 and the calculation servers 24 in advance. Hence, the work contents can be completely understood by the calculation servers 24.

There are many unspecified users. Even a single user may request the next job before the preceding job is ended. For this reason, the management/determination server 22 activates one job in correspondence with one request.

For example, if each of five users issues two requests, 10 jobs can be activated. Since each job has a unique job number, the job contents are not mixed up with each other.

Since even jobs from a single user have different job numbers, their contents are not mixed up.

A job sequentially executes a series of processing operations. When the final processing is ended, the job ends by itself and disappears from the memory space. Hence, for a single user, even before the result of a preceding job is obtained, a new job can be received, and a simulation can be started.

Next, in S6, the management/determination server 22 determines a calculation server 24 that should execute the created job. Some of the plurality of calculation servers 24 are already calculating or in an idle state. In S7, if a calculation server in the idle state is present, it is determined as the calculation server 24. If all calculation servers are busy, a calculation server with the lightest job is selected and determined. If it is impossible, a job wait state is set.

A job list is a page accessible by the user. Its base data is stored in the result list storage section 25. The management/determination server 22 creates the page information of the job list using the data stored in the result list storage section 25. The management/determination server 22 allows the user to selectively browse only jobs of his own or jobs of the user's group.

The management/determination server 22 adds the received job number to the job list and writes the progress situation of the job. That is, the management/determination server 22 writes "in progress" in the job list when the calculation server 24 "starts" executing the job, "standby" in the job list upon determining job wait, and "completed" in the job list when the job is "completed".

Hence, when the calculation server 24 is determined in S7, "calculation in progress" is written in the corresponding job list in S8, and control is transferred to the determined calculation server 24.

If it is determined in S6 that no calculation server can be determined, "standby" is written in the job list in S9 to wait until any calculation server 24 becomes free.

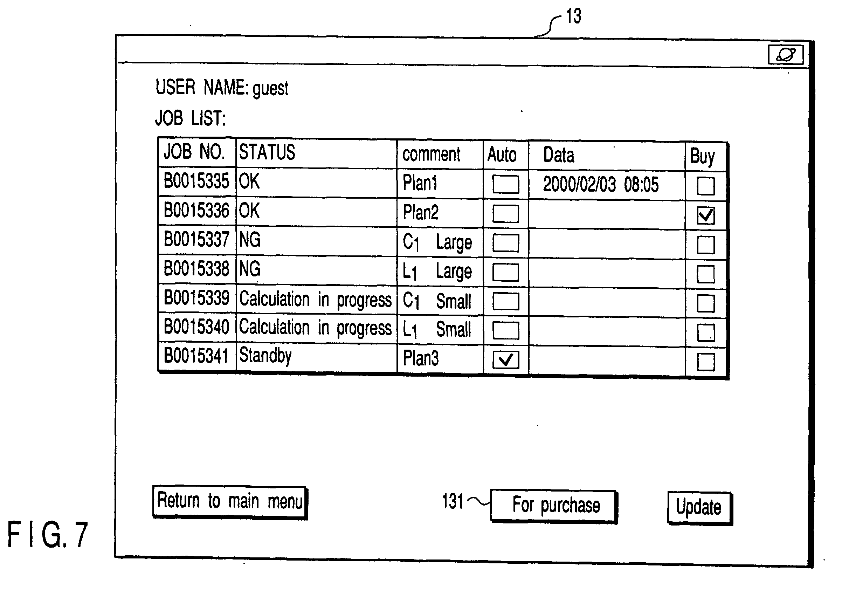

FIG. 7 shows a window in which a user named "guest" displays his job list. Progress situations are displayed in correspondence with job numbers B0015335, B0015336, B0015337,..., B0015341.

Thus, the management/determination server 22 identifies each user, executes a plurality of circuit simulations in parallel, creates a job list for each user, and stores it in the result list storage section 25.

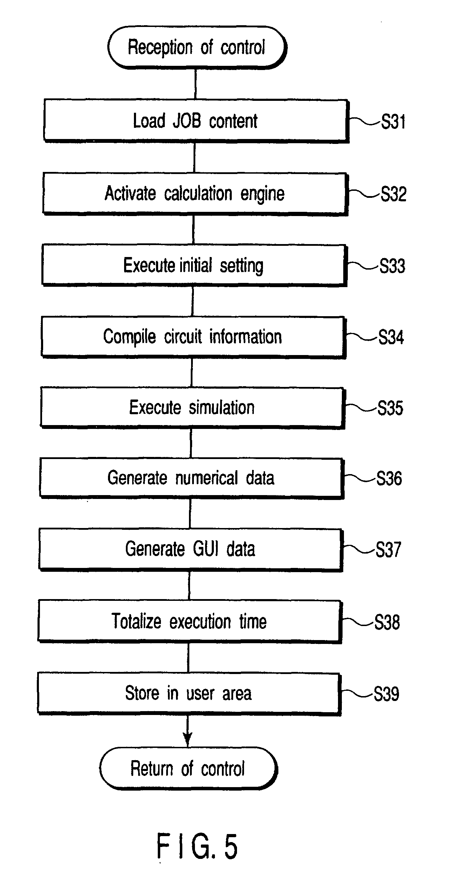

Upon receiving control from the management/determination server 22, the calculation server 24 executes processing shown in FIG. 5. That is, upon receiving control from the management/determination server 22, the calculation server 24 loads the job contents in S31.

The calculation server 24 checks the contents of the received job. The job contents include the circuit modules selected on the client terminal 13, parameters changed from standard parameters, and circuit specifications. If the job contents have no grammatical problem, the calculation server 24 accepts it. Then, pieces of circuit information of the circuit modules selected by the user are extracted from the library 23.

In addition, on the basis of the characteristic parameters of the circuit modules, which are changed by the user, the standard parameters of some circuit elements in the circuit modules are changed.

In this way, the calculation server 24 converts the job contents into data that allows a circuit simulation.

In S32, the calculation server 24 activates the calculation engine by inputting the converted data.

When the calculation engine is activated, an internal variable and the like are initialized, and the circuit information, parameters, and the like are stored in a memory array in S33. The circuit modules are expanded and converted into one whole circuit.

With this processing, the circuit modules are electrically coupled. The parameters of the circuit elements in the circuit modules are directly used as the parameters of the whole circuit. To do this, the names of the circuit elements in all circuit modules are set in the library 23 in advance without any overlap. This simplifies the routine for expanding circuit modules.

Subsequently, in S34, data are compiled to put the circuit information on the calculation algorithm. When compiling is ended, a simulation is started in S35. In S36, the result is generated as numerical data and stored in the user information storage section 26.

If a graph making instruction is written in the job contents, graphic data with a predetermined scale and colors is created on the basis of the numerical data in S37.

When all the instructed works are ended, the times required for execution are totalized in S38. In S39, data such as the request information and simulation results are stored in the user information storage section 26, and the calculation engine is ended. When the calculation engine is ended, the calculation server 24 returns control to the management/determination server 22.

As described above, since simulations are done for the whole circuit, an accurate operation waveform can be obtained.

Upon receiving control from the calculation server 24, the management/determination server 22 analyzes the numerical data stored in the user area in S11. It is determined first in S12 whether the specifications requested by the user are satisfied.

For example, assume that the user has requested to suppress the resonant voltage peak in a steady state to 500 V or less. It is determined as "OK" for 450 V or less and "caution" for 450 to 500 V. It is determined as "NG" if the resonant voltage peak exceeds 500 V. As a determination result, "OK" or "NG" is written in the job list.

If the specifications are satisfied, the analysis is ended. In S13, a characteristic report is made. The characteristic report in which the waveform and numerical value of a circuit portion designated by the user are written is stored in the user information storage section 26.

In S14, a similar article is searched for. That is, if a standard article that is formed from a combination of circuit modules for which standard parameters are set and that has resembling specifications is found, it is recommended as a similar article. For each standard article, data corresponding to a characteristic report is present in the library 23. The characteristic result obtained for the job is compared with the characteristic of a standard article. If the standard article has specifications equivalent to those requested by the user, the standard article is recommended.

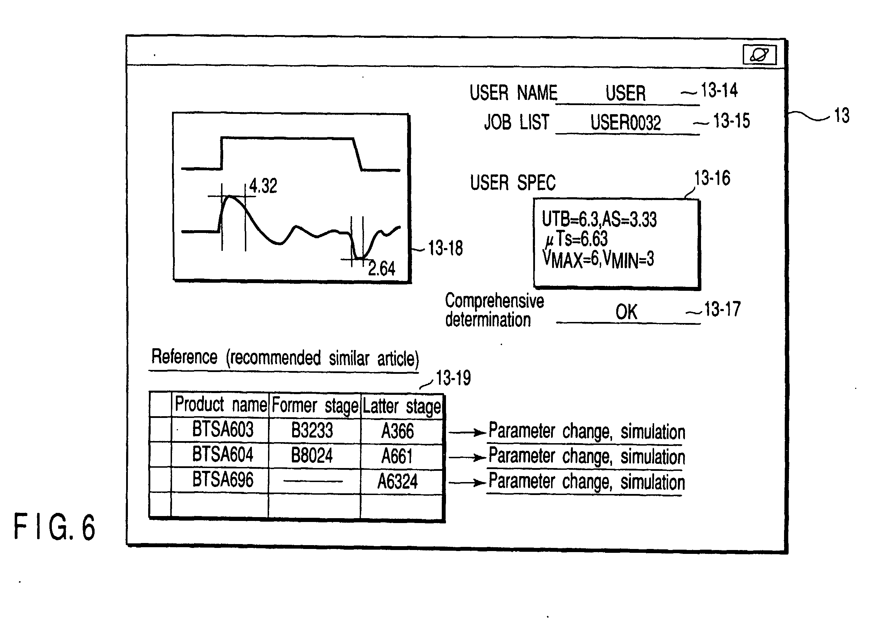

When the user clicks an execution result "OK" on the job list shown in FIG. 7, a characteristic report shown in FIG. 6 is displayed. In the characteristic report, for example, a user name 13-14, job number 13-15, user specifications 13-16, determination result 13-17, and waveform and numerical value 13-18 at a designated circuit portion are displayed. In addition, pieces of information 13-19 of similar articles searched for in S14 are also displayed. This is because the set of circuit modules selected by the user is not always the best.

In S15, a provisional estimate is made up. In each circuit unit that actually implements a circuit module, circuit components are changed from standard circuit components in accordance with changed parameters. For this reason, when an increase or decrease in unit price of each changed circuit component is added to the sum of circuit component unit prices of each basic circuit module, the unit price of the circuit module can be obtained. Various expenses are added to the unit prices, thereby making up a provisional estimate. Finally, in S16, "OK" is written in the job list. Thus, the series of job operations is completed.

When the user updates the job list window on the client terminal 13 at an appropriate time, the corresponding job in the job list window shown in FIG. 7 is changed from "calculation in progress" to "OK". The user can know the progress situation of each job by updating the job list window. When the user clicks the corresponding job in the display window, the characteristic report, similar articles, provisional estimate, and the like can be browsed.

If it is determined in S12 that the specifications are not satisfied, it is determined next in S17 whether the automatic parameter generation option is ON. If it is OFF, a characteristic report for the circuit arrangement that does not satisfy the specifications is made repaired in S18. In S19, a reason for "NG" is analyzed. In S20, grounds for "NG" are made up into a document.

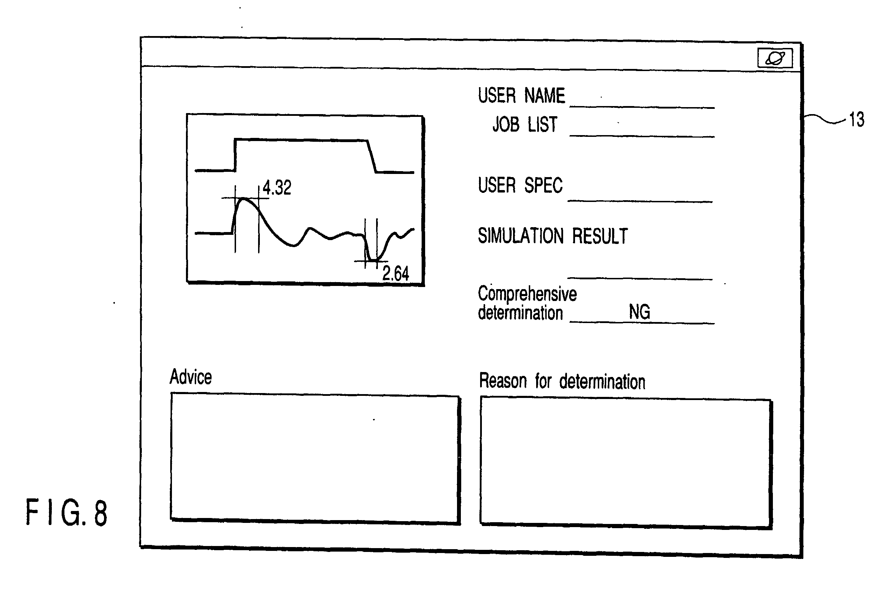

Finally, in S21, "NG" is written in the job list. Thus, the series of job operations is completed. FIG. 8 is a view showing the display window output to the client terminal 13 at this time.

If it is determined in S17 that automatic parameter generation is ON, it is determined in S22 whether automatic parameter generation is possible. That is, a plurality of characteristic parameters are appropriately changed, and it is roughly determined whether each set of characteristic parameters is appropriate.

If the set of parameters is inappropriate, it is determined that automatic parameter generation is impossible. Processing operations in S18 to S21 are sequentially performed, thus completing the series of job operations. If the set of parameters is appropriate, it is determined that automatic parameter generation is possible. In S23, the back data is analyzed.

For the back data, circuit modules used in the user's past jobs, the parameters of the circuit modules, and simulation results are stored in the user information storage section 26 as a history.

It is confirmed by analyzing the back data that the set is a significant set that does not match any job in the past. In S24, sets of parameters of circuit elements in the respective modules are generated from the significant set of characteristic parameters.

Next, the routine is returned to coordinating the job contents in S5. This loop is repeated until the specifications are satisfied. If the specifications cannot be satisfied even by repeating the loop many times, the job may be ended after repeating the loop a predetermined number of times or after the elapse of a predetermined time.

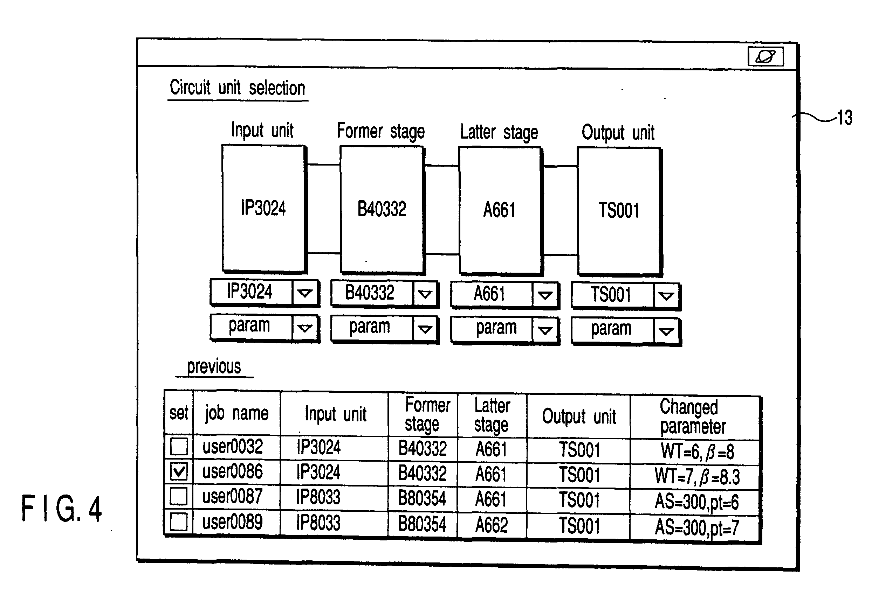

Sets of circuit modules and parameters of the past jobs stored in the user information storage section 26 may be added to the display information for circuit module selection, as shown in FIG. 4. The user can designate to change parameters with reference to the past job contents.

Alternatively, a significant set of circuit modules and parameters may be estimated for the user's circuit specifications using the sets of circuit modules and parameters used in the past jobs stored in the user information storage section 26. The display information of the significant set of circuit modules and parameters may be added to the display information for circuit module selection.

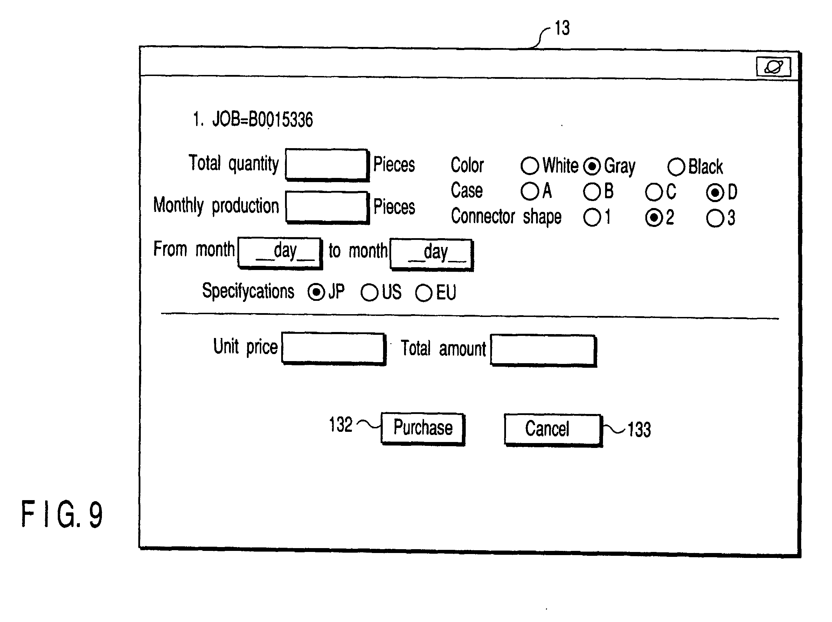

In the job list display window shown in FIG. 7, a button 131 used to buy a circuit is displayed. When the button 131 is clicked, display information to display an order window as shown in FIG. 9 is transmitted to the client terminal.

In this order window, an order for a product that uses the circuit module set and parameters used in a corresponding job can be placed.

In this window, order contents such as the quantity and delivery date are input. When the purchase button 131 is clicked, the management/determination server 22 transmits the order data to the production server 14 connected through the network 11. In the production department, the production server 14 produces the product on the basis of the received order data.

A circuit module developed and designed by a user may be registered in the library 23. If a user consigns a circuit module for sale, it is registered in a consignment library. Circuit modules in the consignment library can be used by the management/determination server 22 and calculation servers 24, like the library 23 prepared in the server system in advance.

Other users can select circuit modules in the consignment library for circuit simulations and make orders for them. In this case, the management/determination server 22 calculates a margin charge based on the contract with a user as a consigner on the basis of the unit price of a circuit module and records the margin charge in the production server 14. The management/determination server 22 also notifies the user as the consigner that the order has been received.

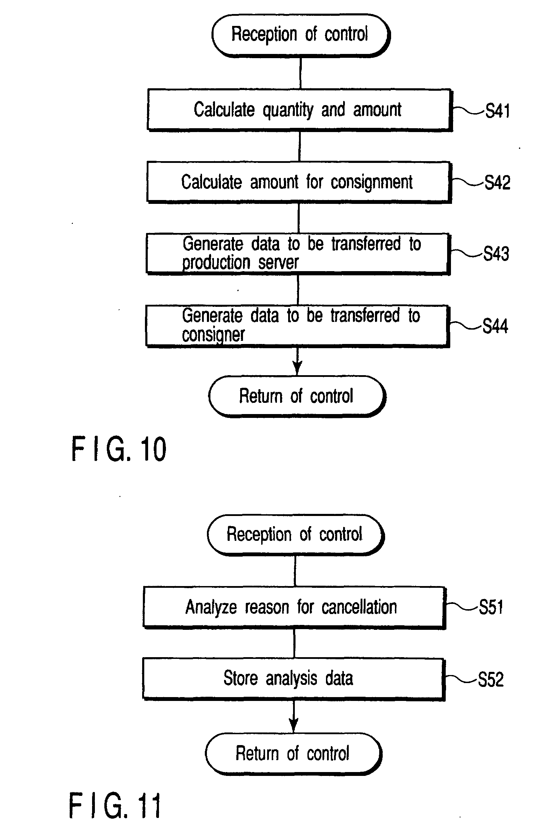

Hence, when a purchase button 132 is clicked in the window shown in FIG. 9, the management/determination server 22 executes processing shown in FIG. 10. In S41, the quantity and amount are calculated. In S42, an amount for consignment is calculated. In S43, data to be transmitted to the production server 14 is generated. In S44, data to be transmitted to the consigner is generated.

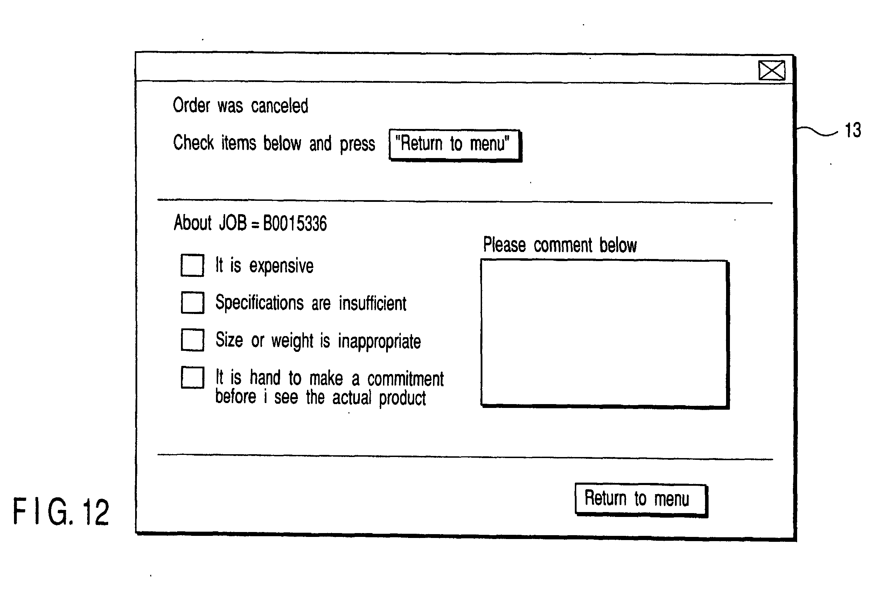

When a cancel button 133 is clicked in the window shown in FIG. 9, a window as shown in FIG. 12 is displayed on the client terminal 13 to make the user input a reason for canceling in a simple questionnaire format.

Upon receiving the reason for canceling, the management/determination server 22 analyzes the reason for canceling in S51 as shown in FIG. 11 and stores the analysis data in S52.

In this system, a custom library may be formed in the library 23 on the basis of a custom circuit designed by a user. When a user wants to design an original circuit and ask the server system to simulate the designed circuit, a customer library is registered in the library 23 by, e.g., a contract with the server manager side.

Circuit modules in the customer library can be used by the management/determination server 22 and calculation servers 24, like the library 23 prepared in the server system in advance.

When the user selects a circuit module in the customer library and executes a circuit simulation, a calculation server use charge is calculated on the basis of a time required to execute the circuit simulation. The user is charged for use of the calculation server.

As described above, quick circuit design for a client is possible, and a circuit that meets a client's specifications can be designed. In addition, standardization is possible because the personality of the user, i.e., designer, does not influence the result of circuit design.

Furthermore, since set circuit modules and parameters that satisfy the circuit specifications requested by the user can be directly transferred to the manufacturing section, order reception and manufacturing can be done quickly.

Since each calculation server 24 has a trial-and-error algorithm, labor required can therefore be reduced. Additionally, since the management/determination server 22 searches for a free calculation server 24, the user's wait time can be shortened.

The user can easily use the simulation software technology by using the World Wide Web instead of buying expensive simulation software.

On the manager side, reasons why the user has canceled purchase in the end can be collected and analyzed. Hence, the circuit module library can be enriched as a library suitable for use by the user.

As has been described above, according to the present invention, the server system acquires circuit module selection information and circuit specification information from the client terminal, executes circuit simulations, and notifies the client terminal of the result of determining whether the result of executed simulations has satisfied the specifications. With this arrangement, a circuit that meets the client's specifications can be designed, and quick circuit design for the client is possible.

### Industrial Applicability

As has been described above, the present invention is effective in a field where a system for realizing circuit design support in a server system for executing circuit simulations in response to a request from a client terminal is manufactured or used. The present invention is also effective in a field where a recording medium which stores a program for realizing circuit design support is manufactured or used.

## Claims

1. A circuit design support method in a server system which receives, through a network, circuit simulation request information transmitted from a client terminal and executes a circuit simulation on the basis of the request information, **characterized by** comprising:
making a library in which a plurality of circuit modules capable of circuit simulations are registered usable on the network;
transmitting to the client terminal display information that allows selecting a circuit module from the library, display information that allows designating a parameter of the circuit module, and display information that allows inputting circuit specifications;
receiving the circuit module selected on the client terminal, the designated parameter, and the input circuit specifications;
executing a circuit simulation using the selected circuit module in consideration of the designated parameter;
determining whether a simulation result satisfies the circuit specifications and storing a determination result in a storage section; and
transmitting the determination result in response to access from the client terminal.

2. A circuit design support method according to claim 1, **characterized by** comprising
transmitting to the client terminal display information that allows selecting a plurality of circuit modules from the library, display information that allows designating parameters for the plurality of circuit modules, and display information that allows inputting circuit specifications,
receiving the plurality of circuit modules selected on the client terminal, the designated parameters, and the circuit specifications,
converting the plurality of selected circuit modules into a whole circuit, and
executing a circuit simulation of the whole circuit in consideration of the designated parameters.

3. A circuit design support method in a server system which receives, through a network, circuit simulation request information transmitted from a client terminal and executes a circuit simulation on the basis of the request information, **characterized by** comprising:
making a library in which a plurality of circuit modules capable of circuit simulations are registered usable on the network;
transmitting to the client terminal display information that allows selecting a plurality of circuit modules from the library and display information that allows inputting specifications of a circuit constituted by the selected circuit modules;
receiving the plurality of circuit modules selected on the client terminal and the input circuit specifications;
generating a significant set of parameters for the plurality of received circuit modules;
converting the plurality of selected circuit modules into a whole circuit;
executing a circuit simulation of the whole circuit in consideration of the significant set of parameters;
determining whether a simulation result satisfies the circuit specifications;
if the circuit specifications are not satisfied, repeating processing of generating a new set of parameters, executing a circuit simulation, and determining a result;
storing a determination result in a storage section; and
transmitting the determination result in response to access from the client terminal.

4. A circuit design support method according to claim 1 or 3, **characterized by** comprising
assigning identification information to each of a plurality of pieces of request information from the client terminal,
executing a simulation for each request information and storing a progress situation of the simulation, and
transmitting display information for displaying the progress situation of the simulation for each identification information in response to access from the client terminal.

5. A circuit design support method according to claim 1 or 3, **characterized by** comprising
identifying a client who is accessing from the client terminal, and assigning identification information to each of a plurality of pieces of received request information,
storing in correspondence with the client the determination result of the circuit simulation corresponding to the request information, and
transmitting display information for displaying the determination result of the circuit simulation for each identification information of the identified client, in response to access from the client terminal.

6. A circuit design support method according to claim 1 or 3, **characterized by** comprising
storing as a history the request information and the determination result of the simulation for the request information,
when new request information is received from the client terminal, estimating a significant set of circuit modules and parameters for the request information from the history, and
transmitting display information for displaying the significant set of circuit modules and parameters, in response to access from the client terminal.

7. A circuit design support method according to claim 1 or 3, **characterized by** comprising
registering in the library a standard circuit formed by combining standard circuit modules,
comparing a circuit characteristic of the circuit simulation for the request information with a circuit characteristic of the standard circuit registered in the library, and
when the circuit characteristics resemble each other, transmitting display information of the standard circuit in response to access from the client terminal.

8. A circuit design support method according to claim 1 or 3, **characterized by** comprising
identifying a client who is accessing from the client terminal, and assigning identification information to each of a plurality of pieces of received request information,
storing the request information for each identified client as a history together with the identification information, and
transmitting display information for displaying the history of the authentic client, in response to access from the client terminal.

9. A circuit design support method according to claim 1 or 3, **characterized by** comprising
calculating a cost of a circuit module changed to the parameter designated by the user, and
in transmitting the stored determination result in response to access from the client terminal, transmitting the calculated cost.

10. A circuit design support method according to claim 1 or 3, **characterized by** comprising
transmitting the stored determination result in response to access from the client terminal, and transmitting display information used to make an order for a circuit, and
receiving the order for the circuit from the client terminal, and transmitting the order for the circuit to a producer-side computer connected through the network.

11. A circuit design support method according to claim 1 or 3, **characterized by** comprising
transmitting the stored determination result in response to access from the client terminal, and transmitting display information used to input an order for a circuit and display information used to input canceling,
when canceling is received from the client terminal, transmitting display information used to input a reason for cancellation to the client terminal, and
receiving the reason for cancellation from the client terminal.

12. A circuit design support method according to claim 1 or 3, **characterized by** comprising
making a library in which a plurality of consigned circuit modules are registered usable on the network,
transmitting the stored determination result in response to access from the client terminal, and transmitting display information used to make an order for a circuit, and
receiving the order for the circuit from the client terminal, and
when the order from the client terminal is for the consigned circuit module, calculating a margin charge on the basis of a contract with a consigner.

13. A circuit design support method according to claim 1 or 3, **characterized by** comprising
making a library, in which a plurality of circuit modules provided by a client are registered, usable on the network,
authenticating the client on the basis of identification information of the client, and
when the authenticated client is a client that has provided the plurality of circuit modules, and a circuit modules selected by the client are the circuit modules, calculating a use charge for the circuit simulation using the circuit modules.

14. A circuit design support system in a server system which receives, through a network, circuit simulation request information transmitted from a client terminal and executes a circuit simulation on the basis of the request information, **characterized by** comprising:
a library in which a plurality of circuit modules capable of circuit simulations are registered;
means for transmitting to the client terminal display information that allows selecting a circuit module from said library, display information that allows designating a parameter of the circuit module, and display information that allows inputting circuit specifications;
means for receiving the circuit module selected on the client terminal, the designated parameter, and the input circuit specifications;
means for executing a circuit simulation using the selected circuit module in consideration of the designated parameter;
means for determining whether a simulation result satisfies the circuit specifications;
means for storing a determination result in a storage section; and
means for transmitting the determination result in response to access from the client terminal.

15. A circuit design support system in a server system which receives, through a network, circuit simulation request information transmitted from a client terminal and executes a circuit simulation on the basis of the request information, **characterized by** comprising:
a library in which a plurality of circuit modules capable of circuit simulations are registered;
means for transmitting to the client terminal display information that allows selecting a plurality of circuit modules from said library and display information that allows inputting specifications of a circuit constituted by the selected circuit modules;
means for receiving the plurality of circuit modules selected on the client terminal and the input circuit specifications;
means for generating a significant set of parameters for the plurality of received circuit modules;
means for converting the plurality of selected circuit modules into a whole circuit;
means for executing a circuit simulation of the whole circuit in consideration of the significant set of parameters;
means for determining whether a simulation result satisfies the circuit specifications;
means for, if the circuit specifications are not satisfied, repeating processing of generating a new set of parameters, executing a circuit simulation, and determining a result;
means for storing a determination result in a storage section; and
means for transmitting the determination result in response to access from the client terminal.

16. A computer-readable recording medium which records a program to cause a server system which receives, through a network, circuit simulation request information transmitted from a client terminal and executes a circuit simulation on the basis of the request information to implement
a function of making a library in which a plurality of circuit modules capable of circuit simulations are registered usable on the network;
a function of transmitting to the client terminal display information that allows selecting a circuit module from the library, display information that allows designating a parameter of the circuit module, and display information that allows inputting circuit specifications;
a function of receiving the circuit module selected on the client terminal, the designated parameter, and the input circuit specifications;
a function of executing a circuit simulation using the selected circuit module in consideration of the designated parameter;
a function of determining whether a simulation result satisfies the circuit specifications and storing a determination result in a storage section; and
a function of transmitting the determination result in response to access from the client terminal.
